# EUROPEAN PATENT APPLICATION

(11) **EP 4 750 245 A1**
(43) Date of publication of application: **27.05.2026**
(21) Application number: 24895999.1
(22) Date of filing: 08.10.2024
(51) Int. Cl.: H10B 80/00, H03F 3/21, H03F 3/19, H10D 64/20, H10W 70/40

(54) **POWER AMPLIFIER, RADIO FREQUENCY MODULE AND ELECTRONIC DEVICE**

(30) Priority: 30.11.2023 CN 202311636607
(71) Applicant: Huawei Technologies Co., Ltd., Shenzhen, Guangdong 518129 (CN)
(72) Inventor: ZHANG, Yawen, Shenzhen, Guangdong 518129 (CN); WEI, Wei, Shenzhen, Guangdong 518129 (CN); LI, Tingzhao, Shenzhen, Guangdong 518129 (CN)
(74) Representative: Körber, Martin Hans
(86) International application number: PCT/CN2024/123307
(87) International publication number: WO 2025/112905

(57) **Abstract**

Embodiments of this application provide a power amplifier, a radio frequency module, and an electronic device. The power amplifier includes a signal input end, a signal output end, and a plurality of dies connected in parallel. The die includes an electrode finger extending in a first direction, and the electrode finger includes a gate finger, a source finger, and a drain finger, the signal input end and the signal output end are respectively located on two sides of the plurality of dies in a second direction, and the second direction and the first direction are perpendicular to each other. In this application, an extension direction of the electrode finger is set to be perpendicular to a signal input/output direction, so that, within a limited layout area, performance of the electrode finger can be improved to a greatest extent, a high-power requirement can be met, and a flexible possibility can be created for a circuit architecture design.

## Description

The present invention claims priority to Chinese Patent Application No. 202311636607.4, filed with the China National Intellectual Property Administration on November 30, 2023 and entitled "POWER AMPLIFIER, RADIO FREQUENCY MODULE, AND ELECTRONIC DEVICE", which is incorporated herein by reference in its entirety.

### TECHNICAL FIELD

This application relates to the field of communication technologies, and specifically, to a power amplifier, a radio frequency module, and an electronic device.

### BACKGROUND

Power amplifiers are widely used in the field of radio frequency wireless communication. Currently, mainstream power amplifiers used in the communication industry include an LDMOS (Laterally Diffused Metal Oxide Semiconductor, laterally diffused metal oxide semiconductor) process, a high-voltage (28 V/48 V) GaN (gallium nitride) process, a GaAs (gallium arsenide) material process, and the like. The GaAs material process includes an HBT (Heterojunction bipolar transistor, heterojunction bipolar transistor) process and a pHEMT (Pseudomorphic High electron mobility transistor, pseudomorphic high electron mobility transistor) process. The LDMOS process and the high-voltage GaN process are mainly used in base station scenarios, while the GaAs HBT process is more commonly used in terminal scenarios. Currently, there are researches on application of new low-voltage GaN processes in the terminal scenarios.

With development of technologies, products have an increasingly high requirement for power. However, under a high-power requirement, a layout structure of a conventional power amplifier occupies large space, failing to meet a requirement for design space.

### SUMMARY

In view of this, this application provides a power amplifier, a radio frequency module, and an electronic device, to resolve a problem in a conventional technology that a layout structure of a conventional power amplifier occupies large space under a high-power requirement.

According to a first aspect, an embodiment of this application provides a power amplifier, including a signal input end, a signal output end, and a plurality of dies connected in parallel. The die includes an electrode finger extending in a first direction, and the electrode finger includes a gate finger, a source finger, and a drain finger, the signal input end and the signal output end are respectively located on two sides of the plurality of dies in a second direction, and the second direction and the first direction are perpendicular to each other.

In the power amplifier provided in this embodiment of this application, an extension direction of the electrode finger is set to be perpendicular to a signal input/output direction, so that a total gate width can be increased by connecting dies in parallel in the second direction of signal input/output, and the total gate width can also be increased by connecting dies in parallel in the first direction in which the electrode finger extends. Therefore, space in the second direction can be fully used, and a length occupied in the first direction can be reduced. In comparison with a conventional component layout manner, there is no need to sacrifice optimal electrical performance of the electrode finger to reduce occupation in the first direction. The power amplifier provided in this embodiment of this application can be applied to a high-voltage GaN-based component, and can also be applied to a low-voltage GaN-based component. Within a limited layout area, performance of the electrode finger can be improved to a greatest extent, a high-power requirement can be met, and a flexible possibility can be created for a circuit architecture design.

The power amplifier includes a gate lead connected to the signal input end and a drain lead connected to the signal output end, the gate finger is connected to the gate lead, and the drain finger is connected to the drain lead. A plurality of dies arranged in the second direction form a die row, and a plurality of dies in one die row share one drain lead and one gate lead, so that the plurality of dies are connected in parallel.

In some implementations, the die row is located between the drain lead and the gate lead that are adjacent to each other. The drain lead and the gate lead are spaced apart by using the die row, so that the power amplifier can be prevented from failing to perform normal output due to coupling of a signal in the drain lead to a signal in the gate lead. Therefore, normal operation of a power amplifier component can be ensured.

In some implementations, the power amplifier includes at least one structure group, the structure group includes two die rows adjacent in the first direction, and the two die rows in the structure group share one gate lead or one drain lead, so that flexible wiring of the gate lead and the drain lead is implemented.

In some implementations, quantities of dies in the two die rows in the structure group are equal. Through this arrangement, the space in the second direction can be properly used, to avoid a waste of space. In addition, the plurality of dies in the power amplifier can be regularly arranged, so that arrangement of the electrode finger has good regularity, which facilitates etching uniformity.

In some implementations, the power amplifier includes n structure groups connected in parallel, the n structure groups are arranged in the first direction, n is a positive integer, and n≥2. During layout design of a component, after a specific quantity of dies are disposed in the die row, a total gate width may be increased by increasing a quantity of structure groups, to meet a power requirement and balance space occupied by an overall component in the first direction and in the second direction.

In some implementations, adjacent dies in the die row share the drain finger and/or the source finger. A first end of the gate lead is connected to the signal input end, a second end of the gate lead is connected to the gate finger, a first end of the drain lead is connected to the drain finger, and a second end of the drain lead is connected to the signal output end. First ends of at least two gate leads that are respectively electrically connected to two adjacent structure groups are electrically connected, and second ends of at least two drain leads that are respectively electrically connected to the two adjacent structure groups are electrically connected. When a quantity of the dies in the die row is fixed, a length occupied by the die row in the second direction can be reduced based on a design in this embodiment of this application, and layout space of the power amplifier can be reduced. In addition, when space in the first direction y needs to be further reduced, the quantity of the dies can be appropriately increased in the die row to meet a high-power requirement.

In some implementations, in at least one die row, two groups of electrode fingers of at least two dies are staggered in the second direction. Through this arrangement, heat consumption distribution in a component can be dispersed, local hot spots can be mitigated, and overall performance reliability of a system can be improved during application.

In some implementations, the at least one die row includes a first die, a second die, and a third die, the second die is located between the first die and the third die, the first die is adjacent to the second die, the third die and the second die are spaced apart by m dies, m is an integer, and m≥0. Two groups of electrode fingers of the first die and the second die are staggered in the second direction, two groups of electrode fingers of the second die and the third die are staggered in the second direction, and the electrode finger of the first die and the electrode finger of the third die are offset or staggered relative to the electrode finger of the second die in a same direction. Through this arrangement, heat consumption distribution in the component can be dispersed, and the width of the die row in the first direction can be minimized, to meet a requirement of a high-power component for layout space. In addition, a phase difference between signals in different dies can be further minimized, thereby ensuring performance of the component.

In some implementations, the power amplifier includes a microstrip line, and the microstrip line includes a first microstrip line and a second microstrip line. The at least one die row includes a fourth die and a fifth die, two groups of electrode fingers of the fourth die and the fifth die are staggered in the second direction, and in the first direction, a distance between the electrode finger of the fourth die and the drain lead is greater than a distance between the electrode finger of the fifth die and the drain lead. A drain finger of the fourth die is electrically connected to the drain lead through the first microstrip line, and a gate finger of the fifth die is electrically connected to the gate lead through the second microstrip line. The first microstrip line and the second microstrip line are disposed, so that a phase difference between output signals of the fourth die and the fifth die can be reduced, making phases remain consistent to a greatest extent, and therefore, combining effect of output signals of parallel dies can be improved, and performance of a component can be improved.

In some implementations, lengths of electrode fingers of at least two of the plurality of dies are unequal. Through this arrangement, a difference between signal transmission paths of different dies can be compensated, to further balance a phase difference between output signals of different dies, enabling final current combining to achieve an optimal output status, thereby improving overall electrical performance of a component.

In some implementations, the plurality of dies include a sixth die and a seventh die, and a length of the electrode finger of the sixth die is greater than a length of the electrode finger of the seventh die. The power amplifier includes a microstrip line. The microstrip line includes a third microstrip line, and the third microstrip line is electrically connected to a gate finger of the seventh die; and/or the microstrip line includes a fourth microstrip line, and the fourth microstrip line is electrically connected to a drain finger of the seventh die. A phase difference between output signals of the seventh die and the sixth die can be balanced by using the microstrip line, so that final current combining reaches an optimal output status, thereby improving overall electrical performance of a component.

According to a second aspect, based on a same inventive concept, an embodiment of this application further provides a radio frequency module, including the power amplifier provided in any embodiment of this application.

According to a third aspect, based on a same inventive concept, an embodiment of this application further provides an electronic device, including the radio frequency module provided in any embodiment of this application.

The power amplifier, the radio frequency module, and the electronic device that are provided in embodiments of this application have the following beneficial effect: An extension direction of an electrode finger is set to be perpendicular to a signal input/output direction, so that a total gate width can be increased by connecting dies in parallel in a second direction of signal input/output, and the total gate width can also be increased by connecting dies in parallel in a first direction in which the electrode finger extends. Therefore, space in the second direction can be fully used, and a length occupied in the first direction can be reduced. In comparison with a conventional component layout manner, there is no need to sacrifice optimal electrical performance of the electrode finger to reduce occupation in the first direction. According to the power amplifier provided in this embodiment of this application, within a limited layout area, performance of the electrode finger can be improved to a greatest extent, a high-power requirement can be met, and a flexible possibility can be created for a circuit architecture design.

### BRIEF DESCRIPTION OF DRAWINGS

To describe technical solutions in embodiments of this application more clearly, the following briefly describes accompanying drawings used for embodiments. It is clear that the accompanying drawings in the following descriptions show merely some embodiments of this application, and a person of ordinary skill in the art may derive other drawings from these accompanying drawings without creative efforts.
FIG. 1 is a diagram of a stacked structure of a GaN component in a conventional technology;
FIG. 2 is a diagram of a stacked structure of a GaAs HBT component in a conventional technology;
FIG. 3 is a diagram of a stacked structure of a GaN component according to an embodiment of this application;
FIG. 4 is a diagram of a structure of a power amplifier in a conventional technology;
FIG. 5 is a diagram of a power amplifier according to an embodiment of this application;
FIG. 6 is a diagram of another power amplifier according to an embodiment of this application;
FIG. 7 is a diagram of another power amplifier according to an embodiment of this application;
FIG. 8 is a diagram of comparison between a power amplifier according to an embodiment of this application and a conventional power amplifier;
FIG. 9 is a diagram of another power amplifier according to an embodiment of this application;
FIG. 10 is a diagram of another power amplifier according to an embodiment of this application;
FIG. 11 is a diagram of another power amplifier according to an embodiment of this application;
FIG. 12 is a diagram of another power amplifier according to an embodiment of this application;
FIG. 13 is a diagram of another power amplifier according to an embodiment of this application;
FIG. 14 is a diagram of another power amplifier according to an embodiment of this application;
FIG. 15 is a diagram of another power amplifier according to an embodiment of this application;
FIG. 16 is a diagram of another power amplifier according to an embodiment of this application; and
FIG. 17 is a diagram of an architecture of a circuit according to an embodiment of this application.

### DESCRIPTION OF EMBODIMENTS

To better understand technical solutions of this application, the following describes embodiments of this application in detail with reference to accompanying drawings.

It should be noted that described embodiments are merely a part rather than all of embodiments of this application. All other embodiments obtained by a person of ordinary skill in the art based on embodiments of this application without creative efforts shall fall within the protection scope of this application.

Terms used in embodiments of this application are merely for the purpose of describing specific embodiments, but are not intended to limit this application. The terms "a", "the", and "this" of singular forms used in embodiments and the appended claims of this application are also intended to include plural forms, unless otherwise specified in the context clearly.

It should be understood that the term "and/or" used in this specification describes only an association relationship between associated objects and indicates that three relationships may exist. For example, A and/or B may indicate the following three cases: Only A exists, both A and B exist, and only B exists. In addition, the character "/" in this specification generally indicates an "or" relationship between the associated objects.

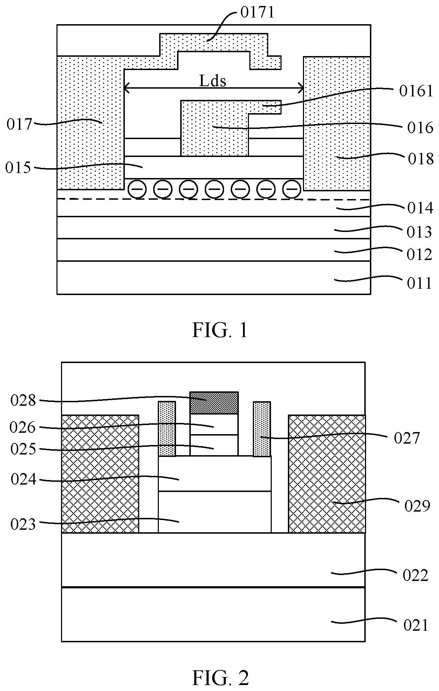

FIG. 1 is a diagram of a stacked structure of a GaN component in a conventional technology. The GaN component in FIG. 1 is a high-voltage GaN component. As shown in FIG. 1, the high-voltage GaN component includes an A1N (aluminum nitride) transition layer 012, an AlGaN (aluminum gallium nitride) buffer layer 013, a GaN channel layer 014, and an AlGaN barrier layer 015 that are stacked on a SiC/Si (silicon carbide/silicon) substrate 011, a gate 016, a source 017, and a drain 018. Based on piezoelectric effect, two-dimensional electron gas is formed on the GaN channel layer 014 along a boundary surface between the GaN channel layer 014 and the AlGaN barrier layer 015 to conduct electricity, and the two-dimensional electron gas is used as a conductive channel between the source 017 and the drain 018. It can be learned from FIG. 1 that a gate field plate 0161 connected to the gate 016 and a source field plate 0171 connected to the source 017 are further disposed in the high-voltage GaN component. A field plate is an important part of the high-voltage GaN component, and has a function of controlling charge distribution and electric field distribution.

FIG. 2 is a diagram of a stacked structure of a GaAs HBT component in a conventional technology. As shown in FIG. 2, the GaAs HBT component includes an n+ GaAs sub-collector region 022, an n GaAs collector region 023, a p+ GaAs base region 024, an n InGaP (indium gallium phosphide) layer 025, and an n+ GaAs layer 026 that are stacked on a GaAs substrate 021, and a base 027, an emitter 028, and a collector 029. The GaAs HBT component is a longitudinal current component.

Currently, high-voltage GaN components are mainly used in base station scenarios, for example, a high-voltage (28 V/48 V) GaN process component, while GaAs HBT components are mainly used in terminal scenarios. However, in the terminal scenarios, the GaAs HBT component has disadvantages in thermal reliability. An embodiment of this application provides a low-voltage GaN power amplifier component, to be used in the terminal scenarios. A terminal product may be, for example, a portable electronic device like a mobile phone, a tablet, or an intelligent wearable product (for example, a watch). An operating voltage (namely, a drain voltage) of the low-voltage GaN power amplifier component provided in this embodiment of this application is Vo, and Vo≤15 V. In some embodiments, Vo≤12 V. Optionally, Vo≥3 V.

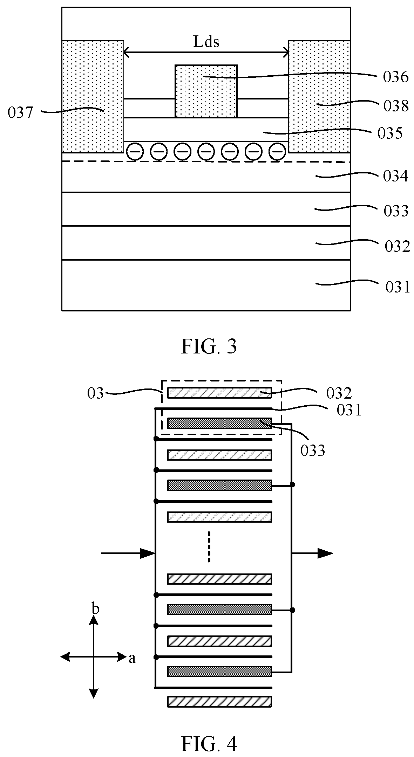

FIG. 3 is a diagram of a stacked structure of a GaN component according to an embodiment of this application. The GaN component in FIG. 3 is a low-voltage GaN component. As shown in FIG. 3, the low-voltage GaN component sequentially includes a SiC/Si substrate 031, an AlN transition layer 032, an AlGaN buffer layer 033, a GaN channel layer 034, an AlGaN barrier layer 035, a gate 036, a source 037, and a drain 038. Optionally, the low-voltage GaN component further includes a nucleation layer, and the nucleation layer is located between the SiC/Si substrate 031 and the AlN transition layer 032. The nucleation layer has a lattice structure and/or a thermal expansion coefficient, and the nucleation layer is suitable for bridging a lattice mismatch and/or a thermal expansion coefficient mismatch between a substrate layer and an upper layer of the substrate layer. Optionally, the low-voltage GaN component further includes an AlN insertion layer, and the AlN insertion layer is located between the GaN channel layer 034 and the AlGaN barrier layer 035. Optionally, the low-voltage GaN component further includes a GaN cap layer, and the GaN cap layer is located on a side that is of the AlGaN barrier layer 035 and that is away from the GaN channel layer 034. In the low-voltage GaN component, two-dimensional electron gas is formed on the GaN channel layer 034 based on piezoelectric effect to conduct electricity. The low-voltage GaN component provided in this embodiment of this application may be manufactured by using the following process: First, the SiC/Si substrate is provided, which has a high resistivity property with sheet resistance greater than 5 kohm.cm, and has a thickness ranging from 50 µm to 300 µm; then, an AlN/AlGaN multi-layer structure is grown on the substrate to form the nucleation layer, the transition layer, and the buffer layer, where a total thickness of the nucleation layer, the transition layer, and the buffer layer approximately ranges from 300 nm to 2 µm; then, the GaN channel layer and the A1N insertion layer are grown, where a total thickness of the GaN channel layer and the A1N insertion layer approximately ranges from 100 nm to 500 nm; then, the barrier layer and the cap layer are grown, where a total thickness of the barrier layer and the cap layer approximately ranges from 5 nm to 30 nm; and finally, the gate, the source, and the drain are manufactured. Manufacturing processes of the gate, the source, and the drain include but are not limited to manners such as evaporation, electroplating, and sputtering. Manufacturing metal of the gate, the source, and the drain includes one or a combination of elements such as Ti (titanium), Al, Ni (nickel), Au (gold), and Pt (platinum).

It can be learned by comparing FIG. 2 with FIG. 3 that the low-voltage GaN component and the GaAs HBT component are of completely different physical structures. It can also be learned from FIG. 1 and FIG. 3 that structures of the low-voltage GaN component and the high-voltage GaN component are also different to some extent. For example, there is no need to dispose a field plate structure in the low-voltage GaN component. In addition, in the low-voltage GaN component, a spacing Lds between the source and the drain is less than or equal to 3 µm, and a thickness of the barrier layer approximately ranges from 5 nm to 20 nm, while in the high-voltage GaN component, a spacing Lds between a source and a drain is greater than or equal to 5 µm, and a thickness of a barrier layer approximately ranges from 25 nm to 35 nm. That is, a size of the low-voltage GaN component is usually less than that of the high-voltage GaN component. Although the sizes of the high-voltage GaN component and the low-voltage GaN component are different, for designing an electrode layout of the low-voltage GaN power amplifier component, refer to a conventional high-voltage GaN power amplifier component.

FIG. 4 is a diagram of a structure of a power amplifier in a conventional technology. FIG. 4 is a schematic top view. As shown in FIG. 4, a structure of a conventional power amplifier includes a plurality of dies 03 connected in parallel, and the die 03 includes a gate finger 031, a source finger 032, and a drain finger 033. The gate finger 031, the source finger 032, and the drain finger 033 all extend in a first direction a, the plurality of dies 03 are arranged in a second direction b and connected in parallel, and the first direction a and the second direction b are perpendicular to each other. The die 03 is a basic unit in the power amplifier, and a large current or high power is combined by connecting the dies 03 in parallel. In FIG. 4, a signal flow direction is indicated by arrows, and a signal is input from the left and output to the right, that is, the signal flow direction of the power amplifier is left-in and right-out. In other words, a signal input/output direction is the first direction a. An extension direction of each electrode finger in FIG. 4 is parallel to the signal input/output direction.

When the power amplifier is designed, a total gate width is equivalent to power. In other words, a larger designed total gate width indicates higher power. In the power amplifier, a width of the gate finger is a gate length, and a length of the gate finger is a gate width. In FIG. 4, the gate width is a length of the gate finger 031 in the first direction a, and the total gate width is a product of a quantity of gate fingers 031 and the length of the gate finger 031. However, such a conventional component layout manner in FIG. 4 has the following problems during high-power application: When a length of a single gate finger 031 is fixed, more dies 03 need to be connected in parallel in the second direction b to meet a high-power requirement. As a result, the component occupies a large length in the second direction b (namely, a direction perpendicular to the signal input/output direction), and when space of a module system is limited, it is difficult to arrange the power amplifier. When a quantity of dies 03 disposed in parallel is fixed, increasing the length of the single gate finger 031 can meet a requirement for the total gate width. However, because a larger length of the gate finger 031 indicates a larger loss, increasing the length of the gate finger 031 is likely to deviate from an optimal finger length for electrical performance, resulting in a severe power loss. It can be learned that the conventional component layout manner cannot meet both a requirement for layout space and a requirement for an optimal length of the electrode finger under the high-power requirement. Especially, when manufacturing a low-voltage GaN power amplifier component for use in a terminal product is considered, a requirement for a miniaturized size of the power amplifier component may also be high.

To resolve a problem existing in a conventional power amplifier layout manner during the high-power application, an embodiment of this application provides a solution. The extension direction of the electrode finger and a signal transmission direction are set to be perpendicular to each other, and layout space in two directions is properly used, so that performance of the electrode finger can be optimized to a greatest extent in a limited layout area condition, and the requirement for the layout space and the requirement for the optimal length of the electrode finger can be met during the high-power application.

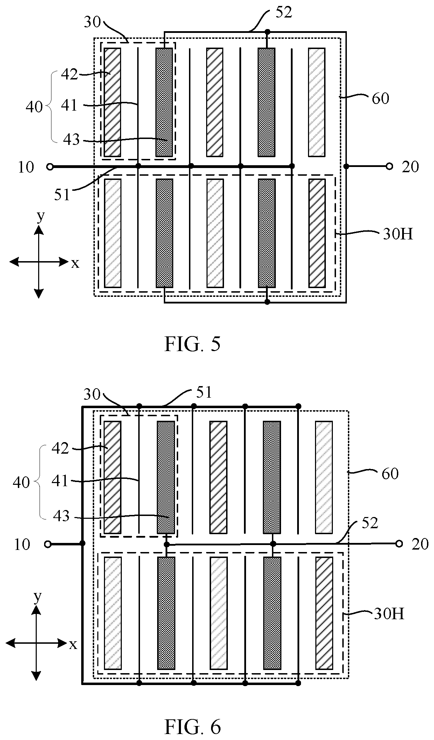

FIG. 5 is a diagram of a power amplifier according to an embodiment of this application. As shown in FIG. 5, the power amplifier includes a signal input end 10, a signal output end 20, and a plurality of dies 30 connected in parallel. The die 30 includes a group of electrode fingers 40 extending in a first direction y. The electrode finger 40 includes a gate finger 41, a source finger 42, and a drain finger 43. A plurality of dies 30 arranged in a second direction x form a row 30H of dies, and the second direction x and the first direction y are perpendicular to each other. Being perpendicular to each other described in this application means being roughly perpendicular to each other. For example, if an included angle between the first direction y and the second direction x is within a range of [95°, 105°], it is considered that the first direction y and the second direction x are perpendicular to each other. A width of the gate finger 41 is less than a width of the source finger 42 and a width of the drain finger 43. The gate finger 41 is indicated by only black thin lines in FIG. 5.

The signal input end 10 and the signal output end 20 are respectively located on two sides of the plurality of dies 30 in the second direction x. A signal in the power amplifier shown in FIG. 5 is input from the left and output to the right, that is, a signal input/output direction is the second direction x.

FIG. 5 is a schematic top view of the power amplifier. As shown in FIG. 5, "the electrode fingers extending in a first direction y" means that a length direction of the electrode finger 40 is the first direction y, and a corresponding width direction of the electrode finger 40 is the second direction x. "The signal input end 10 and the signal output end 20 are respectively located on two sides of the plurality of dies 30 in the second direction x" means that the signal input end 10 and the signal output end 20 are respectively provided on the two sides of the plurality of dies 30 in the second direction x. In some implementations, a non-zero included angle is formed between the second direction x and a virtual connection line between the signal input end 10 and the signal output end 20. In another embodiment, the virtual connection line between the signal input end 10 and the signal output end 20 is in the second direction x. "A plurality of dies 30 arranged in a second direction x" means that the dies 30 are spaced apart in the second direction x, and specifically, the width direction of the electrode finger 40 of the die 30 is the second direction x. In other words, a width direction of the die 30 is the second direction x.

As shown in FIG. 5, the power amplifier further includes a gate lead 51 and a drain lead 52. The gate finger 41 is connected to the signal input end 20 through the gate lead 51, and the drain finger 43 is connected to the signal output end 20 through the drain lead 52. A signal input end by the signal input end 10 enters, through the gate lead 51, gate fingers 41 of the plurality of dies 30 connected in parallel, and then signals output by drain fingers 43 of the plurality of dies 30 are combined through the drain lead 52 and then output from the signal output end 20.

In the power amplifier provided in this embodiment of this application, an extension direction of the electrode finger 40 is set to be perpendicular to a signal input/output direction, so that a total gate width can be increased by connecting dies 30 in parallel in the second direction x of signal input/output, and the total gate width can also be increased by connecting dies 30 in parallel in the first direction y in which the electrode finger 40 extends. Through this arrangement, space in the second direction x can be fully used, and a length occupied in the first direction y (namely, a direction perpendicular to the signal input/output direction) can be reduced. In addition, in comparison with a conventional component layout manner, there is no need to sacrifice optimal electrical performance of the electrode finger 40 to reduce occupation in the first direction y. In embodiments of this application, within a limited layout area, performance of the electrode finger can be improved to a greatest extent, a high-power requirement can be met, and a flexible possibility can be created for a circuit architecture design.

In some implementations, as shown in FIG. 5, a plurality of dies 30 in one row 30H of dies share one drain lead 52 and one gate lead 51. In other words, a plurality of drain fingers 43 in a same row 30H of dies are connected to a same drain lead 52, and a plurality of gate fingers 41 in a same row 30H of dies are connected to a same gate lead 51, so that the plurality of dies 30 are connected in parallel.

Optionally, both the gate lead 51 and the drain lead 52 extend in the second direction x. Shapes of the gate lead 51 and the drain lead 52 are not limited to straight lines, and the shapes of the gate lead 51 and the drain lead 52 may alternatively be broken lines or curves. Extension directions of the drain lead 52 and the gate lead 51 are set to intersect with the extension direction of the electrode finger 40, which can facilitate connection between the gate finger 41 and the gate lead 51, and can also facilitate connection between the drain finger 43 and the drain lead 52. This helps reduce winding lengths of leads and use less space.

In some implementations, as shown in FIG. 5, the row 30H of dies is located between the drain lead 52 and the gate lead 51 that are adjacent to each other. In other words, the drain lead 52 and the gate lead 51 that are adjacent to each other are spaced apart by the row 30H of dies. The drain lead 52 and the gate lead 51 are spaced apart, so that the power amplifier can be prevented from failing to perform normal output due to coupling of a signal in the drain lead 52 to a signal in the gate lead 51. Therefore, normal operation of the power amplifier component can be ensured.

As shown in FIG. 5, in the row 30H of dies, adjacent dies 30 share a drain finger 43 or a source finger 42. When a quantity of the dies 30 in the row 30H of dies is fixed, a length occupied by the row 30H of dies in the second direction x can be reduced based on a design in this embodiment of this application, and layout space of the power amplifier can be reduced. In addition, when space in the first direction y needs to be further reduced, the quantity of the dies 30 can be appropriately increased in the row 30H of dies to meet a high-power requirement.

In some implementations, the power amplifier includes a structure group, and one structure group includes two rows 30H of dies. Because the signal input/output direction is the second direction x, it is easy to arrange the leads to connect the rows 30H of dies in the structure group in parallel. That is, a plurality of dies 30 in the structure group are connected in parallel. As shown in FIG. 5, the structure group 60 includes two adjacent rows 30H of dies in the first direction y, and the two rows 30H of dies in the structure group 60 share one gate lead 51. Two drain leads 52 are respectively located on two sides of the structure group 60 in the first direction y. In this implementation, a signal is input from the gate lead 51 located at the middle of the two rows 30H of dies, and then output signals from upper and lower sides of the structure group 60 are combined and then output.

In some other implementations, the two die rows in the structure group share one drain lead. FIG. 6 is a diagram of another power amplifier according to an embodiment of this application. As shown in FIG. 6, a structure group 60 includes two adjacent rows 30H of dies in a first direction y, and the two rows 30H of dies in the structure group 60 share one drain lead 52. Two gate leads 51 are respectively located on two sides of the structure group 60 in the first direction y. In this implementation, signals are input from the gate leads 51 located on upper and lower sides of the structure group 60, and then output signals are combined between the two rows 30H of dies and then output.

As shown in FIG. 5 or FIG. 6, quantities of dies 30 in the two rows 30H of dies in the structure group 60 are equal. Through this arrangement, the space in the second direction x can be properly used, to avoid a waste of space. In addition, the plurality of dies 30 in the power amplifier can be regularly arranged, so that arrangement of the electrode finger 40 has good regularity, which facilitates etching uniformity.

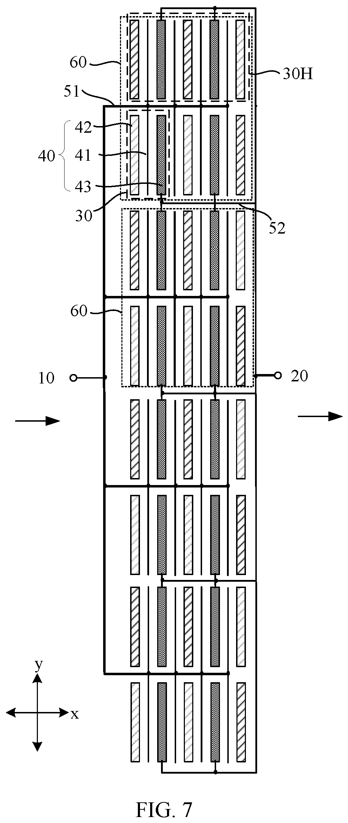

In some implementations, the power amplifier includes n structure groups 60 connected in parallel, the n structure groups 60 are arranged in the first direction y, n is a positive integer, and n≥2. For example, n=4. FIG. 7 is a diagram of another power amplifier according to an embodiment of this application. As shown in FIG. 7, the power amplifier includes four structure groups 60 connected in parallel, and each structure group 60 includes two rows 30H of dies. The row 30H of dies includes four dies 30 connected in parallel. In this case, each structure group 60 includes eight dies 30, and the power amplifier includes 32 dies 30 in total. During layout design of a component, after a specific quantity of dies 30 are disposed in the row 30H of dies, a total gate width may be increased by increasing a quantity of structure groups 60, to meet a power requirement and balance space occupied by an overall component in the first direction y and in the second direction x.

It can be learned from FIG. 7 that a first end of a gate lead 51 is connected to a signal input end 10, a second end of the gate lead 51 is connected to a gate finger 41, a first end of a drain lead 52 is connected to a drain finger 43, and a second end of the drain lead 52 is connected to a signal output end 20. First ends of at least two gate leads 51 that are respectively electrically connected to two adjacent structure groups 60 are electrically connected, and second ends of at least two drain leads 52 that are respectively electrically connected to the two adjacent structure groups 60 are electrically connected. In this way, the two adjacent structure groups 60 are connected in parallel. As shown in FIG. 7, two rows 30H of dies in one structure group 60 share one gate lead 51. In other words, one gate lead 51 and two drain leads 52 need to be disposed for one structure group 60. In this case, the first ends of the two gate leads 51 that respectively correspond to the two adjacent structure groups 60 are electrically connected. As shown in FIG. 7, the two adjacent structure groups 60 have one shared drain lead 52, and the two drain leads 52 that are respectively used by the two adjacent structure groups 60. In other words, the second ends of the two drain leads 52 respectively electrically connected to the two adjacent structure groups 60 are electrically connected. In some other implementations, the two adjacent structure groups 60 may not share the drain lead 52. In this case, two drain leads 52 are correspondingly disposed in each structure group 60, and second ends of four drain leads 52 respectively electrically connected to the two adjacent structure groups 60 are electrically connected.

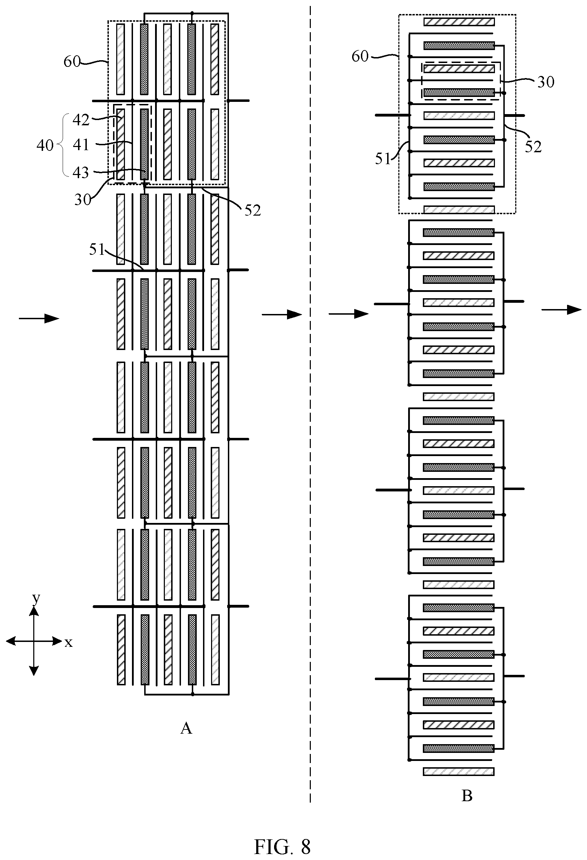

FIG. 8 is a diagram of comparison between a power amplifier according to an embodiment of this application and a conventional power amplifier. A in FIG. 8 is a diagram of a layout of the power amplifier according to this embodiment of this application. B in FIG. 8 is a diagram of a layout of the conventional power amplifier. For example, each structure group 60 includes eight dies 30. A length of a gate finger 41 is 125 µm, that is, a gate width of a single finger is 125 µm, and a total gate width is 4 mm. Four structure groups 60 are included in each of FIG. A and FIG. B. In FIG. A, a gate lead 51 and a drain lead 52 are extended in a second direction x. In FIG. B, a gate lead 51 and a drain lead 52 are extended in a first direction y. Other process conditions (conditions such as a gate length and a spacing between a source and a drain) in FIG. A are the same as those in FIG. B. In FIG. 8, a signal transmission direction is indicated by arrows. It may be understood that a signal is input from the left and output to the right. In the layout of the conventional power amplifier, an extension direction of an electrode finger is parallel to a signal input/output direction, while in this embodiment of this application, an extension direction of an electrode finger 40 is designed to be perpendicular to a signal input/output direction. It can be learned by comparing FIG. A with FIG. B that, when total gate widths are the same, a design in this embodiment of this application is used, to appropriately use space in the second direction x, so that space occupied by a component in the first direction y can be reduced.

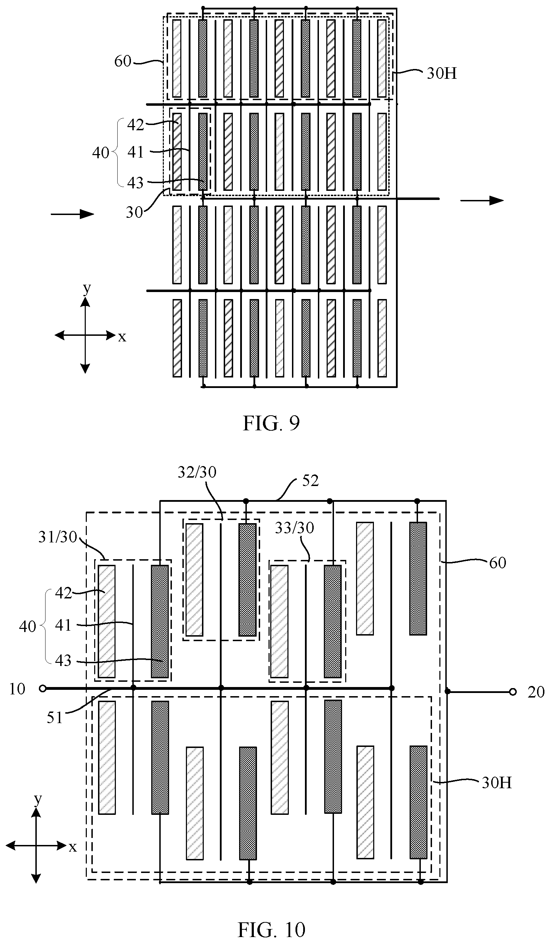

In A in FIG. 8, an example in which a single die row includes four dies 30 is used. To meet a requirement for the total gate width, more dies 30 may be further connected in parallel in the die row. FIG. 9 is a diagram of another power amplifier according to an embodiment of this application. As shown in FIG. 9, one row 30H of dies includes eight dies 30, and two structure groups 60 are arranged in a first direction y. When all other process conditions such as a length of an electrode finger 50 and a spacing between a source finger 42 and a drain finger 43 in FIG. 9 are the same as those in A in FIG. 8, a design requirement for a total gate width can also be met in FIG. 9. In comparison with the design in A in FIG. 8, in the embodiment of FIG. 9, 50% of space in the first direction y can be further saved. A design in the embodiment of FIG. 9 is used, so that component arrangement can be more compact, space occupied by the component in a second direction x is appropriately increased, and a quantity of structure groups 60 connected in parallel in the first direction y can be reduced. Therefore, the space occupied by the component in the first direction y can be further reduced.

In some implementations, two groups of electrode fingers 40 of at least two dies 30 in at least one row 30H of dies are staggered in the second direction x. The two dies 30 whose the electrode fingers 40 are staggered may be adjacent or may not be adjacent to each other.

FIG. 10 is a diagram of another power amplifier according to an embodiment of this application. As shown in FIG. 10, at least one row 30H of dies includes a first die 31 and a second die 32, and an electrode finger 40 of the first die 31 and an electrode finger 40 of the second die 32 are staggered in a second direction x. In other words, the electrode finger 40 of the first die 31 is not aligned with the electrode finger 40 of the second die 32 in the second direction x. Through this arrangement, heat consumption distribution in a component can be dispersed, local hot spots can be mitigated, and overall performance reliability of a system can be improved during application.

In the electrode finger 40, lengths of a gate finger 41, a source finger 42, and a drain finger 43 are basically equal. Two groups of electrode fingers 40 of two adjacent dies 20 are staggered in the second direction x, and a length of stagger between the two groups of electrode fingers 40 in a first direction y is L. L is not greater than a half of a length of the electrode finger 40. In this way, impact of a large length of a single row 30H of dies in the first direction y on space occupied by the component in the first direction y can be avoided. In addition, impact of an excessive large signal phase difference between the adjacent dies 30 on effect of combining output signals can be avoided.

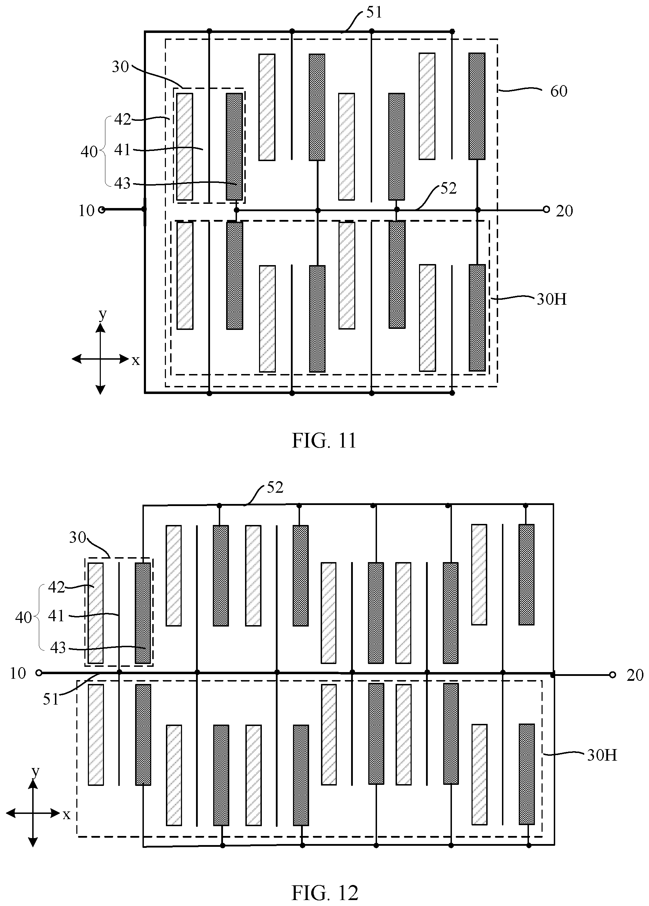

That two rows 30H of dies in one structure group 60 share one gate lead 51 is shown in FIG. 10. In some other implementations, FIG. 11 is a diagram of another power amplifier according to an embodiment of this application. As shown in FIG. 11, two rows 30H of dies in a structure group 60 share one drain lead 52, and two groups of electrode fingers 40 of at least two dies 30 in at least one row 30H of dies are staggered in a second direction x.

As shown in FIG. 10, the at least one row 30H of dies includes the first die 31, the second die 32, and a third die 33. The second die 32 is located between the first die 31 and the third die 33. The first die 31 is adjacent to the second die 32. The third die 33 and the second die 32 are spaced apart by m dies, where m is an integer, and m≥0. m=0 is shown in FIG. 10. Two groups of electrode fingers 40 of the first die 31 and the second die 32 are staggered in the second direction x, two groups of electrode fingers 40 of the second die 32 and the third die 33 are staggered in the second direction x, and the electrode finger 40 of the first die 31 and the electrode finger 40 of the third die 33 are offset or staggered relative to the electrode finger 40 of the second die 32 in a same direction. In other words, two groups of electrode fingers 40 of the first die 31 and the third die 33 are offset or staggered relative to the electrode finger 40 of the second die 32 in a direction away from a drain lead 52 connected to these three dies 30, or the electrode finger 40 of the second die 32 is offset or staggered relative to the two groups of electrode fingers 40 of the first die 31 and the third die 33 in a direction away from a gate lead 52 connected to these three dies 30.

It can be learned from a top view of a layout in FIG. 10 that the electrode finger 40 of the second die 32 is offset upward relative to the two groups of electrode finger 40 of the first die 31 and the third die 33. It is considered that, if the electrode finger 40 of the second die 32 is designed to be offset upward relative to the electrode finger 40 of the first die 31, and the electrode finger 40 of the third die 33 is designed to be offset upward relative to the electrode finger 40 of the second die 32, a width that is of the row 30H of dies in which the three dies 30 are located and that is in the first direction y is increased, and an overall size of the component is affected. In addition, a phase difference among current signals in the three dies 30 is increased, affecting performance of the component. However, a design in this embodiment of this application is used, so that heat consumption distribution in the component can be dispersed, and the width of the row 30H of dies in the first direction y can be minimized, to meet a requirement of a high-power component for layout space. In addition, a phase difference between signals in different dies 30 can be further minimized, thereby ensuring the performance of the component.

In some implementations, as shown in FIG. 10, two groups of electrode fingers 40 of any two adjacent dies 30 in the row 30H of dies are staggered in the second direction x, and electrode fingers 40 of odd-numbered dies 30 are offset or staggered relative to electrode fingers 40 of even-numbered dies 30 in a same direction. Through this arrangement, heat consumption in the component can be more dispersed, and performance reliability of the component can be further improved.

In some other implementations, FIG. 12 is a diagram of another power amplifier according to an embodiment of this application. As shown in FIG. 12, in a row 30H of dies, two groups of electrode fingers 40 of two adjacent dies 30 are staggered in a second direction x, and in addition, two groups of electrode fingers 40 of two adjacent dies 30 are aligned in the second direction x. There are two or more dies 30 that are continuously aligned.

The two dies 30 that are adjacent to each other and that are aligned as shown in FIG. 12 do not share an electrode finger. In some other implementations, in the row 30H of dies, the two groups of electrode fingers 40 of the two adjacent dies 30 are staggered in the second direction x, and in addition, the two groups of electrode fingers 40 of the two adjacent dies 30 are aligned in the second direction x. The two dies 30 that are adjacent to each other and that are aligned do not share a source finger 42 or a drain finger 43. No further drawings are provided for description herein.

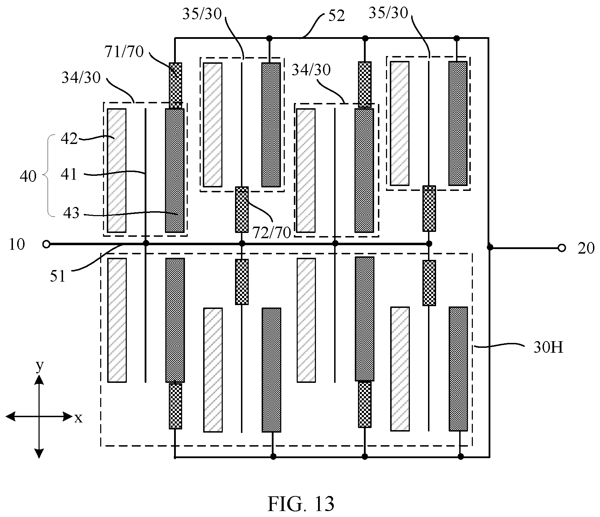

In some other implementations, two groups of electrode fingers 40 of at least two dies 30 in at least one row 30H of dies are staggered in the second direction x, and a microstrip line is disposed in the power amplifier to balance a phase difference between signals in different dies 30. FIG. 13 is a diagram of another power amplifier according to an embodiment of this application. As shown in FIG. 13, the power amplifier includes a microstrip line 70. The microstrip line 70 is a transmission line, and a loss of a signal transmitted on the microstrip line 70 is small. The microstrip line 70 includes a first microstrip line 71 and a second microstrip line 72. Two groups of electrode fingers 40 of a fourth die 34 and a fifth die 35 are staggered in a second direction x. In a first direction y, a distance between the electrode finger 40 of the fourth die 34 and a drain lead 52 is greater than a distance between the electrode finger 40 of the fifth die 35 and the drain lead 52. A drain finger 43 of the fourth die 34 is electrically connected to the drain lead 52 through the first microstrip line 71, and a gate finger 41 of the fifth die 35 is electrically connected to a gate lead 51 through the second microstrip line 72. Because the distance between the electrode finger 40 of the fourth die 34 and the drain lead 52 is long, a transmission distance of a signal output by the fourth die 34 to the drain lead 52 is long. The first microstrip line 71 is disposed between the drain finger 43 of the fourth die 34 and the drain lead 52, so that a loss of the signal output by the fourth die 34 can be reduced. Because a distance between the electrode finger 40 of the fifth die 35 and the gate lead 51 is long, a transmission distance of an input signal transmitted by the gate lead 51 to the fifth die 35 is long. The second microstrip line 72 is disposed between the gate finger 41 of the fifth die 35 and the gate lead 51, so that a loss of the input signal provided for the fifth die 35 can be reduced. In this implementation, the first microstrip line 71 and the second microstrip line 72 are disposed, so that a phase difference between output signals of the fourth die 34 and the fifth die 35 can be reduced, making phases remain consistent to a greatest extent, and therefore, combining effect of output signals of parallel dies 30 can be improved, and performance of a component can be improved.

In the embodiment of FIG. 10, to describe a manner in which dies 30 are staggered, three dies that are sequentially arranged are named a first die 31, a second die 32, and a third die 33. In FIG. 13, to describe a manner in which a microstrip line 70 is disposed, the dies are named a fourth die 34 and a fifth die 35. When a solution in which the microstrip line 70 is disposed in the embodiment in FIG. 13 is applied to the embodiment in FIG. 10, it may be understood that in FIG. 10, the first die 31 and the third die 33 are equivalent to the fourth die 34, and the second die 32 is equivalent to the fifth die 35. A first microstrip line 71 may be correspondingly disposed for the first die 31 and the third die 33, and a second microstrip line 72 may be disposed for the second die 32.

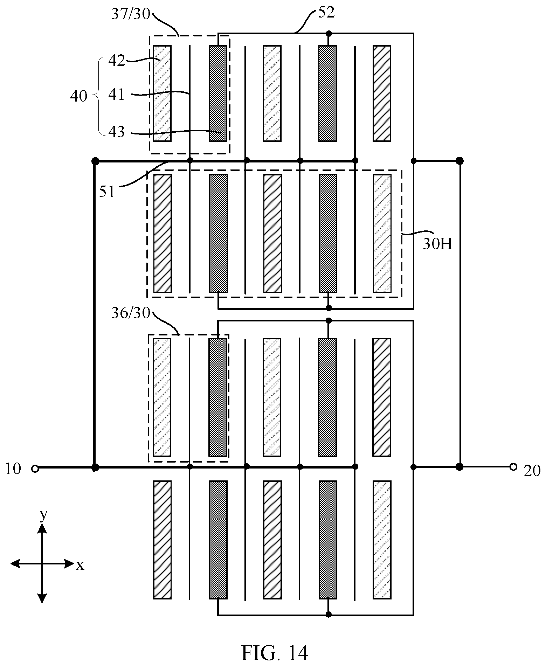

In some implementations, lengths of electrode fingers 40 of at least two dies 30 in a power amplifier are not equal. The dies 30 with the electrode fingers 40 of the unequal lengths may be located in a same row 30H of dies, or may be located in different rows 30H of dies. FIG. 14 is a diagram of another power amplifier according to an embodiment of this application. As shown in FIG. 14, a plurality of dies 30 include a sixth die 36 and a seventh die 37, and a length of an electrode finger 40 of the sixth die 36 is greater than a length of an electrode finger 40 of the seventh die 37. FIG. 13 shows a signal input end 10 and a signal output end 20. It can be learned that, in a 1^{st} row 30H of dies from top to bottom, both a distance between a die 30 and the signal input end 10 and a distance between the die 30 and the signal output end 20 are long, the seventh die 37 is located in the 1^{st} row 30H of dies, and both a distance between the sixth die 30 and the signal input end 10 and a distance between the sixth die 36 and the signal output end 20 are short. It may be understood that a signal transmission path passing through the seventh die 37 is greater than a signal transmission path passing through the sixth die 36. A length difference between the electrode finger 40 of the sixth die 36 and the electrode finger 40 of the seventh die 37 is set, so that a difference between signal transmission paths of the electrode finger 40 of the sixth die 36 and the electrode finger 40 of the seventh die 37 can be compensated, to further balance a phase difference between output signals of the electrode finger 40 of the sixth die 36 and the electrode finger 40 of the seventh die 37, enabling final current combining to achieve an optimal output status, thereby improving overall electrical performance of a component.

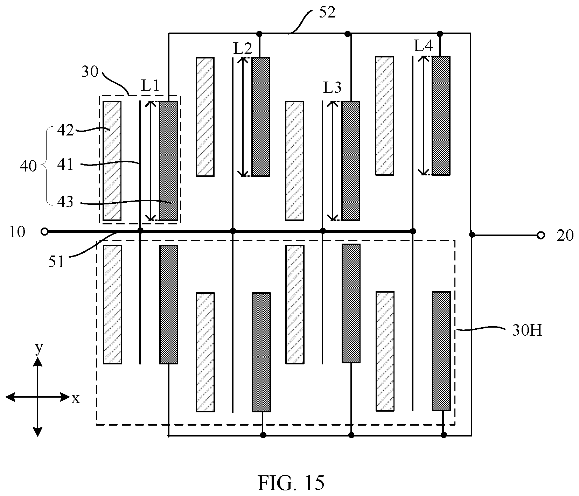

FIG. 14 shows a case in which the dies 30 with the electrode fingers 40 of the unequal lengths are located in different rows 30H of dies. In some other implementations, the dies 30 with the electrode fingers 40 of the unequal lengths are disposed in a same row 30H of dies. FIG. 15 is a diagram of another power amplifier according to an embodiment of this application, and uses an example in which two groups of electrode fingers 40 of two adjacent dies 30 in a row 30H of dies are staggered in a second direction x. As shown in FIG. 15, the row 30H of dies includes four dies 30, and lengths of electrode fingers 40 of the four dies 30 from left to right are respectively L1, L2, L3, and L4. For example, L1=L4, L2=L3, and L1#L2. For another example, L1=L2, L3=L4, and L3≠L2. In practice, the length of the electrode finger 40 of the die 30 may be set based on a specific position of the die 30. The length of the electrode finger 40 of each die 30 is optimized, so that combining of currents output by a plurality of dies 30 can reach an optimal output status, thereby improving overall electrical performance of a component.

In the embodiment of FIG. 15, two groups of electrode fingers 40 of two adjacent dies 30 in the row 30H of dies are staggered in the second direction x, and the row 30H of dies includes dies 30 with electrode fingers 40 of unequal lengths, thereby further optimizing the length of the electrode finger 40 of the die 30 while heat consumption in a structure group can be dispersed, so that combining of currents output by the plurality of dies 30 can reach the optimal output status.

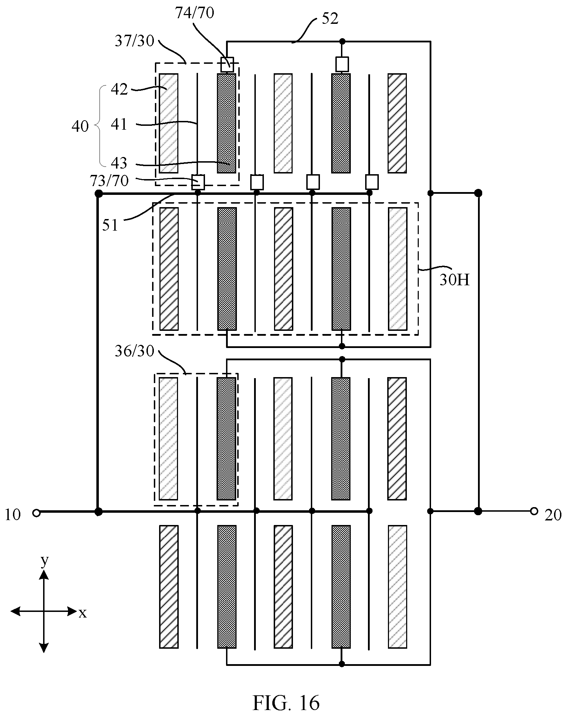

In some other implementations, FIG. 16 is a diagram of another power amplifier according to an embodiment of this application. As shown in FIG. 16, a length of an electrode finger 40 of a sixth die 36 is greater than a length of an electrode finger 40 of a seventh die 37. A microstrip line 70 includes a third microstrip line 73, and the third microstrip line 73 is electrically connected to a gate finger 41 of the seventh die 37; and/or the microstrip line 70 includes a fourth microstrip line 74, and the fourth microstrip line 74 is electrically connected to a drain finger 43 of the seventh die 37. In this implementation, the microstrip line 70 is disposed to connect to the seventh die 37, so that a phase difference between output signals of the seventh die 37 and the sixth die 36 can be balanced by using the microstrip line 70, so that final current combining reaches an optimal output status, thereby improving overall electrical performance of a component.

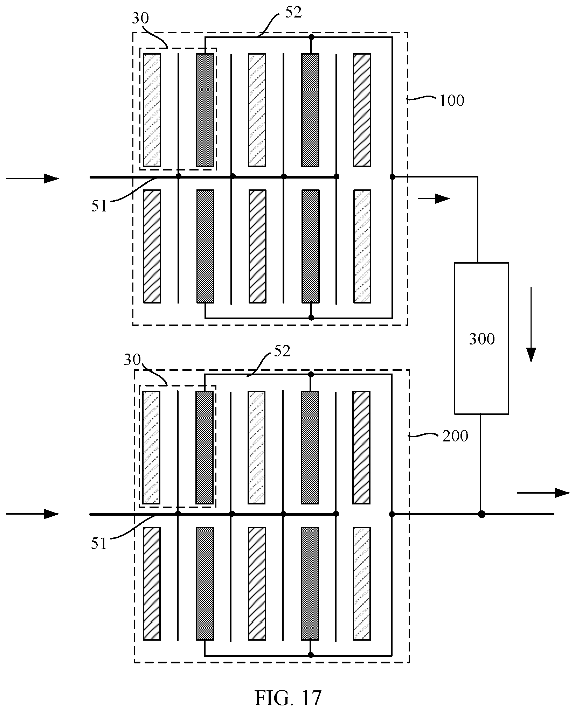

In some implementations, FIG. 17 is a diagram of an architecture of a circuit according to an embodiment of this application. As shown in FIG. 17, the circuit includes a first power amplifier 100 and a second power amplifier 200. A signal flow direction is indicated by arrows in FIG. 17. A signal output end of the first power amplifier 100 is connected to a functional circuit 300, and an output end of the functional circuit 300 is connected to a signal output end of the second power amplifier 200. In other words, a signal output by the first power amplifier 100 is provided to the functional circuit 300, and a signal output by the functional circuit 300 and a signal output by the second power amplifier 200 are integrated and then output. Based on a design in this embodiment of this application, space occupied by the first power amplifier 100 and the second power amplifier 200 can be reduced, to arrange a high-power power amplifier component in limited layout space, so that it is possible to achieve another efficient power amplifier architecture in a module system.

In the accompanying drawings of the foregoing embodiments, a source lead connected to the source finger 42 of the die 30 is not shown. Optionally, the source lead is grounded. With reference to FIG. 3, it is understood that a source 037 (that is, the source finger 42) is connected to the source lead through a via below for penetrating a substrate 031.

Based on a same inventive concept, an embodiment of this application further provides a radio frequency module. The radio frequency module includes the power amplifier provided in any embodiment of this application. A structure of the power amplifier has been described in the foregoing embodiment. Details are not described herein again. The radio frequency module provided in this embodiment of this application may be, for example, a radio frequency front-end module.

Based on a same inventive concept, an embodiment of this application further provides an electronic device. The electronic device includes the radio frequency module provided in any embodiment of this application. The electronic device may be, for example, a terminal product like a mobile phone, a television, a tablet computer, an e-book, or an in-vehicle display.

For same or similar parts of embodiments of this specification, refer to each other. Especially, apparatus and terminal embodiments are basically similar to a method embodiment, and therefore are described briefly. For related parts, refer to partial descriptions in the method embodiment.

## Claims

1. A power amplifier, comprising a signal input end, a signal output end, and a plurality of dies connected in parallel, wherein
the die comprises an electrode finger extending in a first direction, the electrode finger comprises a gate finger, a source finger, and a drain finger, the signal input end and the signal output end are respectively located on two sides of the plurality of dies in a second direction, and the second direction and the first direction are perpendicular to each other.

2. The power amplifier according to claim 1, wherein
the power amplifier comprises a gate lead connected to the signal input end and a drain lead connected to the signal output end, the gate finger is connected to the gate lead, and the drain finger is connected to the drain lead; and
the plurality of dies arranged in the second direction form a die row, and a plurality of dies in one die row share one drain lead and one gate lead.

3. The power amplifier according to claim 2, wherein
the die row is located between the drain lead and the gate lead that are adjacent to each other.

4. The power amplifier according to claim 3, wherein
the power amplifier comprises at least one structure group, and the structure group comprises two die rows adjacent in the first direction; and
the two die rows in the structure group share one gate lead or one drain lead.

5. The power amplifier according to claim 4, wherein
quantities of dies in the two die rows in the structure group are equal.

6. The power amplifier according to claim 4, wherein
the power amplifier comprises n structure groups connected in parallel, the n structure groups are arranged in the first direction, n is a positive integer, and n≥2;
a first end of the gate lead is connected to the signal input end, a second end of the gate lead is connected to the gate finger, a first end of the drain lead is connected to the drain finger, and a second end of the drain lead is connected to the signal output end; and
first ends of at least two gate leads that are respectively electrically connected to two adjacent structure groups are electrically connected, and second ends of at least two drain leads that are respectively electrically connected to the two adjacent structure groups are electrically connected.

7. The power amplifier according to claim 2, wherein
in the die row, adjacent dies share the drain finger and/or the source finger.

8. The power amplifier according to claim 2, wherein
in at least one die row, two groups of electrode fingers of at least two dies are staggered in the second direction.

9. The power amplifier according to claim 8, wherein
the at least one die row comprises a first die, a second die, and a third die, the second die is located between the first die and the third die, the first die is adjacent to the second die, the third die and the second die are spaced apart by m dies, m is an integer, and m≥0; and
two groups of electrode fingers of the first die and the second die are staggered in the second direction, two groups of electrode fingers of the second die and the third die are staggered in the second direction, and the electrode finger of the first die and the electrode finger of the third die are offset or staggered relative to the electrode finger of the second die in a same direction.

10. The power amplifier according to claim 8, wherein
the power amplifier comprises a microstrip line, and the microstrip line comprises a first microstrip line and a second microstrip line;
the at least one die row comprises a fourth die and a fifth die, two groups of electrode fingers of the fourth die and the fifth die are staggered in the second direction, and in the first direction, a distance between the electrode finger of the fourth die and the drain lead is greater than a distance between the electrode finger of the fifth die and the drain lead; and
the drain finger of the fourth die is electrically connected to the drain lead through the first microstrip line, and the gate finger of the fifth die is electrically connected to the gate lead through the second microstrip line.

11. The power amplifier according to claim 2, wherein
lengths of the electrode fingers of at least two of the plurality of dies are unequal.

12. The power amplifier according to claim 11, wherein
the plurality of dies comprise a sixth die and a seventh die, and a length of the electrode finger of the sixth die is greater than a length of the electrode finger of the seventh die;
the power amplifier comprises a microstrip line; and
the microstrip line comprises a third microstrip line, and the third microstrip line is electrically connected to the gate finger of the seventh die; and/or the microstrip line comprises a fourth microstrip line, and the fourth microstrip line is electrically connected to the drain finger of the seventh die.

13. The power amplifier according to claim 1, wherein
a material of the power amplifier comprises gallium nitride.

14. The power amplifier according to claim 1, wherein
an operating voltage of the power amplifier is Vo, and Vo≤15 V.

15. A radio frequency module, comprising the power amplifier according to any one of claims 1 to 14.

16. An electronic device, comprising the radio frequency module according to claim 15.
